Europäisches Patentamt

(19) **European Patent Office**

Office européen des brevets

(11) Numéro de publication: **0 130 645**
**B1**

(12) ## FASCICULE DE BREVET EUROPEEN

(45) Date de publication du fascicule du brevet:
**26.08.87**

(51) Int. Cl.⁴: **H 03 K 3/037**, H 03 K 3/356

(21) Numéro de dépôt: **84200914.4**

(22) Date de dépôt: **25.06.84**

(54) **Diviseur de fréquence par deux.**

(30) Priorité: **29.06.83 FR 8310739**

(43) Date de publication de la demande:
**09.01.85 Bulletin 85/2**

(45) Mention de la délivrance du brevet:
**26.08.87 Bulletin 87/35**

(84) Etats contractants désignés:
**DE FR GB IT**

(56) Documents cités:
**ELECTRONICS, vol. 53, no. 22, octobre 1980, pages 76-78, New York, US; K. DREYFACK: "Gallium arsenide to yield 5-GHz divider"**
**IEE PROCEEDINGS, vol. 127, no. 5, partie 1, octobre 1980, pages 287-295, Stevenage, Herts., GB; G. NUZILLAT et al.: "Low pinch-off voltage f.e.t. logic (l.p.f.l.): l.s.i. oriented logic approach using quasinormally off GaAs m.e.s.f.e.t.s."**
**INTERNATIONAL JOURNAL OF ELECTRONICS, vol. 46, no. 2, février 1979, pages 161-165, Londres, GB; R.A. STARTIN: "Performance of hybid GaAs MESFET logic"**

(73) Titulaire: **Laboratoires d'Electronique et de Physique Appliquée L.E.P., 3, Avenue Descartes, F-94450 Limeil-Brévannes (FR)**
(84) Etats contractants désignés: **FR**

(73) Titulaire: **N.V. Philips' Gloeilampenfabrieken, Groenewoudseweg 1, NL-5621 BA Eindhoven (NL)**
(84) Etats contractants désignés: **DE GB IT**

(72) Inventeur: **Rocchi, Marc, Société Civile S.P.I.D. 209 rue de l'Université, F-75007 Paris (FR)**

(74) Mandataire: **Landousy, Christian et al, Société Civile S.P.I.D. 209, Rue de l'Université, F-75007 Paris (FR)**

## Description

L'invention concerne un circuit diviseur de fréquence par deux, du type bascule maître-esclave à deux sorties complémentaires Q et $\overline{Q}$, intégré à l'aide de transistors à effet de champ, sur un substrat en arséniure de gallium, ne comportant qu'une entrée pour un signal de commande hyperfréquence.

Un tel circuit est connu de l'état de la technique, par la publication de G. Nuzillat et alii, dans IEEE PROC., vol. 127, no 5, octobre 1980, pages 287 à 296. Ce circuit connu est composé de huit portes NON-OU-OU, et est réalisé dans une logique incluant des transistors à effet de champ à enrichissement, à faible tension de pincement, dits quasi-normalement pincés en l'absence de signal grille-source. L'étage inverseur élémentaire est associé à un étage translateur de niveau qui a l'avantage d'utiliser les mêmes alimentations que l'étage inverseur lui-même. De plus ce circuit est d'une faible consommation. En revanche, il est présenté comme fonctionnant à faible vitesse, et d'un rendement de fabrication également assez faible.

Le résultat des recherches de ces dernières années, également présenté dans le document cité comme état de la technique ainsi que dans l'article intitulé: «Gallium arsenide to yield 5 GHz divider» publié dans «Electronics», vol. 53, no 22, (october 9, 1980, p. 76–78), fait apparaître que, en comparant les différentes logiques utilisant les MESFET, la logique BFL-2 diodes (dont l'étage translateur comprend deux diodes) permet d'obtenir les temps de transit les plus courts. D'autre part cette logique BFL, dans laquelle les transistors présentent des couches épaisses (150 nm ou 0,150 µm pour un dopage N d'environ $2.10^{-17}$ cm$^{-3}$), est, non seulement rapide, mais d'une mise en œuvre aisée, avec un bon rendement de fabrication.

Dans cette logique BFL, du fait que l'on choisit comme transistor inverseur, un transistor à désertion de charges, pour lequel la tension de pincement est $V_T < O$, la sortie d'une porte à fonction d'inverseur n'est pas compatible avec l'entrée d'une autre porte. Il est nécessaire d'utiliser un étage translateur de niveau, constitué généralement d'un transistor monté en drain commun (drain relié à l'alimentation continue $V_{DD}$) qui fonctionne en adaptation d'impédance et en suiveur.

La fonction inverseur est réalisée par un transistor monté en source commune (source à la masse) associé à une charge qui peut être active, par exemple un transistor dont la grille et la source sont court-circuitées, cette liaison grille-source étant reliée au drain du transistor inverseur, le drain du transistor de charge étant relié à l'alimentation continue notée $V_{DD}$, l'entrée du signal étant sur la grille du transistor inverseur, la sortie du signal étant sur le drain de ce même transistor.

La translation de niveau proprement dite est faite par des diodes polarisées par une source de courant, cette dernière étant réalisée par un transistor à effet de champ supplémentaire, dont la grille et la source court-circuitées sont reliées à une tension continue $V_{SS}$ différente de la masse. La sortie du signal se fait alors sur le drain de ce dernier transistor, lequel est, par ailleurs, relié aux diodes.

En logique BFL, les configurations qui permettent de réaliser les fonctions NON-OU sont les mêmes que les fonctions utilisées en logique MOS (Metal Oxyde Semiconductor), à cela près qu'il faut utiliser l'étage translateur de niveau.

On notera de plus que, dans une telle logique BFL, la fonction OU (OR) peut être réalisée par la mise en commun des diodes des étages translateurs de deux inverseurs, réalisant ainsi une fonction OU-CABLE, sans augmentation du temps de propagation du signal.

Il est important de définir ici le temps de transit (en anglais Tpd: time propagation delay): c'est la durée minimale de temps nécessaire pour qu'une charge placée sur la grille d'un transistor induise le transfert, à travers le canal de ce transistor, d'une charge identique, sur la grille du transistor de l'étage suivant.

Ces données étant posées, il apparaît que si l'on veut réaliser un diviseur de fréquence par deux, du type bascule T maître-esclave, dans le domaine des hyperfréquences, trois conditions doivent être remplies:

1) les circuits doivent être réalisés sur une grande échelle, de l'ordre de plusieurs millions, donc présenter un coût de fabrication réduit et une technologie facile à mettre en œuvre.

2) les circuits doivent travailler en hyperfréquence, c'est-à-dire à une fréquence de l'ordre de 5 GHz.

3) les portes doivent présenter un temps de propagation du même ordre de grandeur approximativement que la période, pour pouvoir faire fonctionner la bascule maître-esclave en diviseur de tension.

De l'étude de l'art antérieur exposé plus haut, il ressort que l'on peut remplir les trois conditions requises en réalisant un circuit de type bascule T maître-esclave en logique BFL en arséniure de gallium.

Mais si l'on transpose purement et simplement le circuit connu de bascule maître-esclave publié dans le premier document cité précédemment, on perd le bénéfice de la rapidité due à cette logique. Et, en outre, on risque que n'obtenir qu'un circuit instable et qui ne fonctionne pas. En effet, dans une telle bascule, vitesse est toujours synonyme d'instabilité.

Enfin, le second document cité présente un circuit utilisant à la fois des portes NOR et AND. Or, la logique BFL ne peut utiliser de portes AND, pour la raison exposée ci-après: une porte AND est constituée de deux transistors en série représentant deux entrées non équivalentes. Pour une tension d'alimentation typiquement de 4V, en logique BFL, celui des deux transistors qui est monté en source commune voit appliquer sur sa grille une tension variant entre 0,5 et –5V, ce qui impose une tension d'au moins 0,3V au point intermédiaire entre ces deux transistors. On ne peut donc avoir plus de 0,2 V entre la grille et la source du second transistor. Ce qui entraîne une dégradation non négligeable du niveau logique 1.

Dans ces conditions, la présente invention apporte une solution aux différents problèmes posés dans le préambule en proposant un diviseur de fréquence par 2, constitué par une bascule T, remarquable en ce que d'abord le «maître» est constitué de deux portes NON-OU ($G_1$, $G_2$), dont la première porte NON-OU $G_1$ admet pour entrées le signal de commande H et le premier signal de sortie rebouclé $\overline{Q}$ et dont la deuxième porte NON-OU $G_2$ admet pour entrées, le même signal de commande H et le deuxième signal de sortie Q rebouclé, en ce que, ensuite, «l'esclave» est constitué de quatre portes NON-OU ($G_3$, $G_4$, $G_5$, $G_6$) dont la première porte NON-OU $G_3$ admet pour entrées le signal de sortie $E_1$ de la première porte NON-OU $G_1$ du «maître» et le premier signal de sortie $\overline{Q}$ rebouclé, dont la seconde porte NON-OU $G_4$ admet pour entrées le premier signal de sortie $\overline{Q}$ et le signal de commande H, dont la troisième porte NON-OU $G_5$ admet pour entrées le signal de commande H et le deuxième signal de sortie Q rebouclé, et dont la quatrième porte NON-OU $G_6$ admet pour entrées le deuxième signal de sortie Q rebouclé et le signal de sortie $E_2$ de la seconde porte NON-OU $G_2$ du maître, les sorties des deux premières portes NON-OU $G_3$ et $G_4$ de l'esclave étant reliées entre elles sous la forme d'un OU-CABLE ($G_7$) pour donner le deuxième signal de sortie Q, et les sorties des deux dernières portes, $G_5$ et $G_6$, de l'esclave étant reliées entre elles sous forme d'un OU-CABLE ($G_8$) pour donner le premier signal de sortie $\overline{Q}$, et en ce que les différents transistors sont de dimensions telles que, le temps de transit $\tau_1$ dans le maître, le temps de transit $\tau_3$ de la première et de la deuxième porte NON-OU $G_3$ et $G_4$ de l'esclave et le temps de transit $\tau_4$ de la troisième et la quatrième porte NON-OU $G_5$ et $G_6$ donnent l'inégalité suivante: $\tau_1 > (\tau_3 + \tau_4)$. Ainsi le diviseur de fréquence présente un temps de propagation total réduit, une consommation faible et un fonctionnement stable en hyperfréquence.

La description suivante en se référant aux figures annexées fera mieux comprendre comment l'invention est réalisée.

La figure 1 montre le schéma électrique du circuit de bascule T maître-esclave réalisé à l'aide de portes NON-OU et OU.

La figure 2a montre le schéma d'une porte NON-OU en logique BFL.

La figure 2b montre le schéma électrique du circuit de bascule T maître-esclave réalisé en remplaçant la figuration symbolique des portes NON-OU par la représentation en portes-inverseur en logique BFL, telles que définies dans le préambule.

La figure 3 montre les différentes étapes d'acquisition ou de transfert des signaux d'entrées ou de sorties.

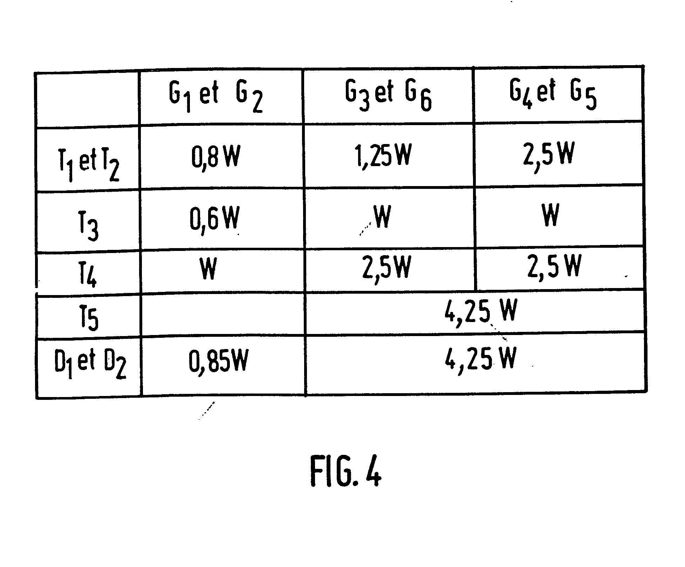

La figure 4 est un tableau des dimensions des transistors.

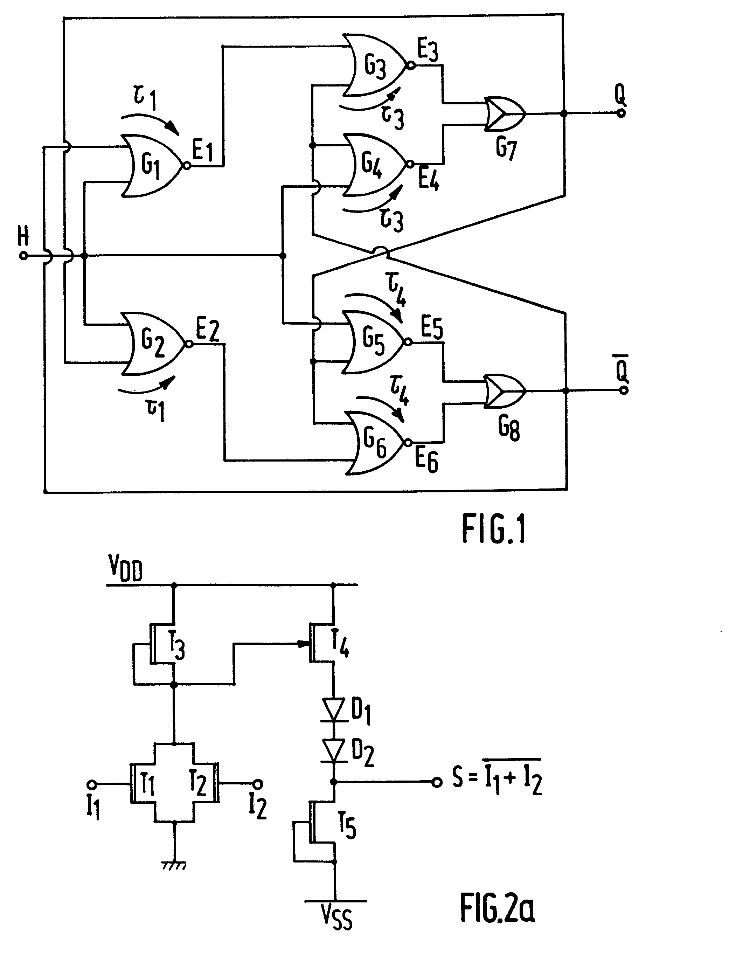

Tel que représenté sur la figure 1, le circuit selon l'invention est donc constitué de deux étages, un étage maître et un étage esclave. L'étage maître comprend les deux portes NON-OU notées $G_1$ et $G_2$, et l'étage esclave les quatre portes NON-OU notées $G_3$, $G_4$, $G_5$, $G_6$ ainsi que les portes OU-CABLE notées $G_7$ et $G_8$, ces dernières n'apportant aucun temps de transit supplémentaire. Le signal de commande H est appliqué sur une entrée de chacune des portes $G_1$ et $G_2$ du maître ainsi que sur une entrée de chacune des portes $G_4$ et $G_5$ de l'esclave, donnant à ces portes $G_4$ et $G_5$ un rôle particulier.

Le maître ne comporte pas d'effet mémoire et ce sont les sorties Q et $\overline{Q}$ des OU-CABLES $G_7$ et $G_8$ qui constituent les secondes entrées des portes $G_2$ et $G_1$ respectivement. Le temps de transit dans une porte $G_1$ ou $G_2$ est noté $\tau_1$.

Par contre, l'étage esclave comporte un effet mémoire, et les sorties $E_3$ et $E_4$ de $G_3$ et $G_4$ court-circuitées constituent le deuxième signal de sortie Q qui est rebouclé sur une des entrées de $G_5$ et $G_6$. De même les sorties $E_5$ et $E_6$ de $G_5$ et $G_6$ court-circuitées constituent le premier signal de sortie $\overline{Q}$ (Q complémentaire) rebouclé sur une des entrées de $G_3$ et $G_4$. Enfin la deuxième entrée de $G_3$ et $G_5$ est reliée aux sorties $E_1$ et $E_2$ de $G_1$ et $G_2$ respectivement. Le temps de transit dans $G_3$ ou $G_4$ est noté $\tau_3$ et le temps de transit dans $G_5$ ou $G_6$ est noté $\tau_4$.

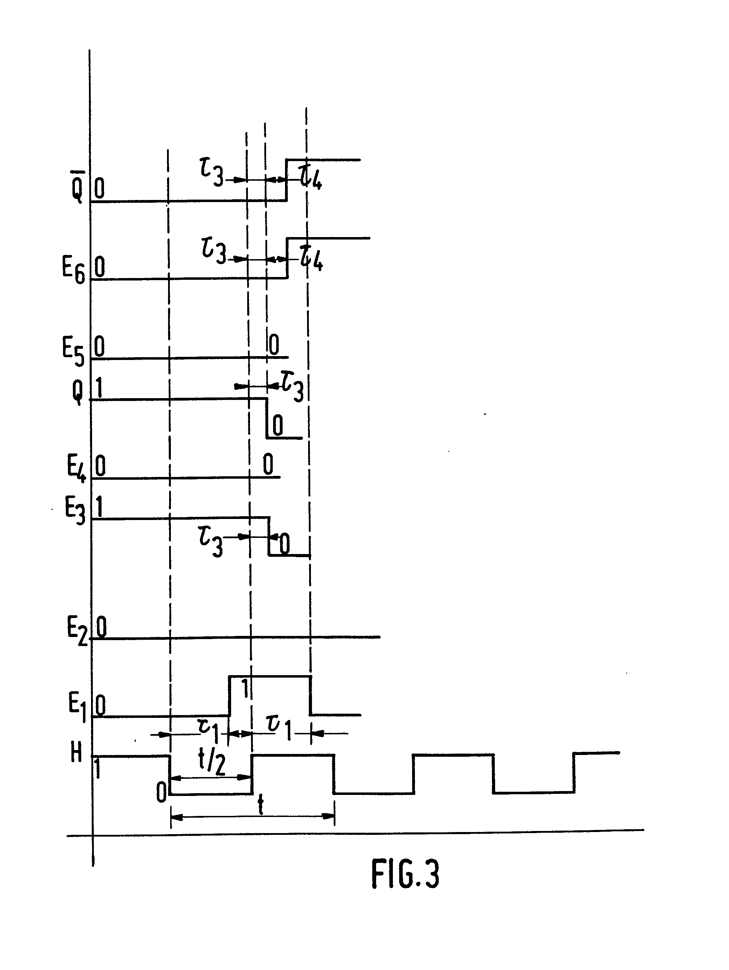

Comme le montre la figure 3, lorsque le signal de commande H est à l'état haut (H=1), les sorties $E_1 = E_2 = 0$, ce qui entraîne que les sorties $E_3 = 1$, $E_4 = 0$ donc Q = 1 et que $E_5 = E_6 = 0$ et $\overline{Q} = 0$. Lorsque le signal H passe de 1 à 0, en supposant que l'on soit parti d'un étage où Q = 1 et $\overline{Q} = 0$, $E_1$ passe à 1 au bout du temps $\tau$ et $E_2$ reste à 0. Les autres états restent inchangés. Seul le maître s'ouvre. Au bout du temps $\tau_1$ après la transition du signal H, l'information est présente sur l'esclave.

Lorsque le signal H passe de 0 à 1, l'information $E_1 = 1$ est la seule présente sur l'esclave avec celle du signal H = 1 et les informations précédentes Q = 1, $\overline{Q} = 0$. Ce qui fait que au bout du temps $\tau_3$ après cette transition du signal H, $E_3 = 0$, $E_4 = 0$ et Q = 0. Il faut alors un temps supplémentaire $\tau_4$ pour qu'en ramenant Q = 0, que l'on vient d'obtenir, sur $G_5$ et $G_6$, on obtienne $E_5 = 0$ et $E_6 = 1$, ce qui donne $\overline{Q} = 1$. Mais il faut que cette opération soit terminée avant que l'information $E_1 = 0$ induite par le passage du signal H de 0 à 1, n'arrive et ne vienne perturber la fin de l'opération de basculement de l'esclave.

On a vu qu'il fallait un temps $\tau_3$ pour que Q bascule plus un autre temps $\tau_4$ pour que $\overline{Q}$ bascule à son tour. Si $\tau_1$ est le temps de transit dans $G_1$, pour que $E_1$ ne perturbe pas le basculement, il faut que $\tau_1 \geqslant (\tau_3 + \tau_4)$.

Puisqu'il faut un temps $\tau_1$ pour que l'information circule dans le maître et un temps $\tau_3$ et $\tau_4$ pour que l'information soit disponible à la sortie de l'esclave, la fréquence maximale de fonctionnement est donné par la relation:

$$f_{max} = 1 / (\tau_1 + \tau_3 + \tau_4)$$

La fréquence maximale est donc plus grande que celle que l'on obtient par les circuits où le maître et l'esclave présentent une fonction mémoire et où dans ce cas:

$f_{max} \simeq 1/4\,\tau$, $\tau$ étant le temps de propagation d'une porte.

En choisissant $\tau_1 \simeq 2\,\tau_3 \simeq 2\,\tau_4 \simeq \dfrac{t}{2}$, t étant la période du signal de commande, la fréquence du signal en sortie est donnée par la relation $f = \dfrac{1}{2t}$.

Telle que représentée sur la figure 2a, la porte NON-OU en logique BFL comprend deux transistors à désertion de charges $T_1$ et $T_2$, en parallèle, montés en source commune, dont le drain est lié aux électrodes grille-source court-circuitées du transistor de charge $T_3$ monté en drain commun. Le drain des transistors $T_1$ et $T_2$ est relié à la grille du transistor suiveur $T_4$ monté en drain commun, dont la source est liée à deux diodes $D_1$ et $D_2$ montées en série entre $T_4$ et la source de courant $T_5$. Les deux entrées équivalentes de la porte NON-OU sont sur les grilles des transistors $T_1$ et $T_2$. La sortie se fait sur le drain du transistor $T_5$ entre $T_5$ et $D_2$.

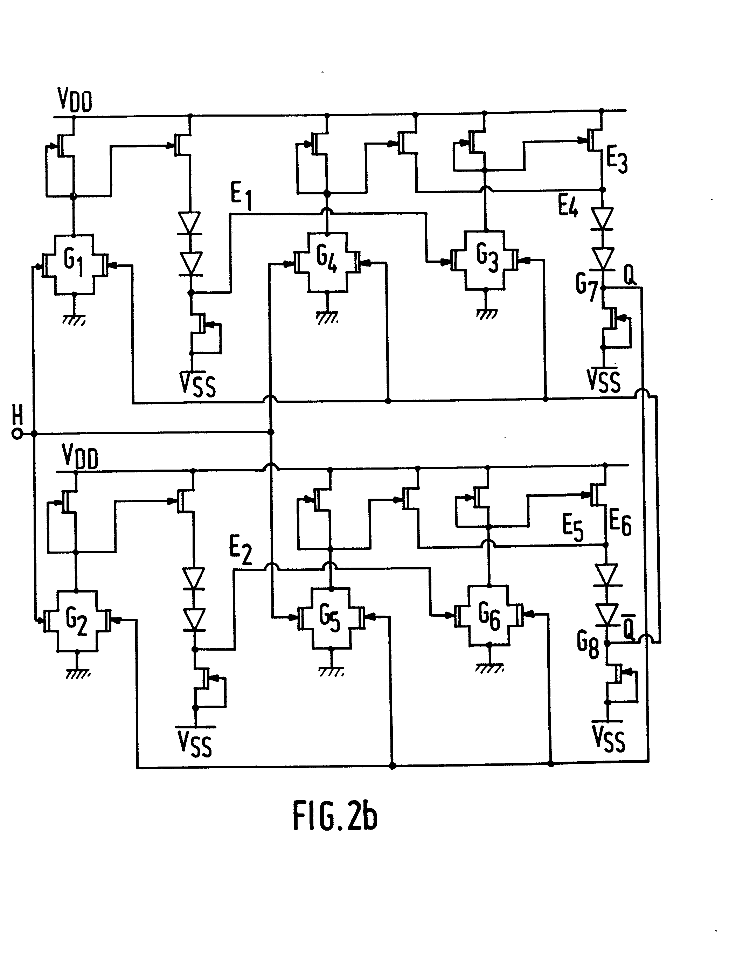

Tel que représenté sur la figure 2b, le schéma logique de la figure 1 est dessiné à l'aide des portes NON-OU représentées sur la figure 2a.

Cependant le OU-CABLE est réalisé de façon particulière. Pour les portes $G_3$ et $G_4$, les diodes $D_1$ et $D_2$ ainsi que le transistor $T_5$ sont mis en commun. Pour l'ensemble de ces deux portes il y a donc 2 transistors suiveurs $T_4$, mais un seul étage translateur avec $D_1$, $D_2$, $T_5$. La sortie Q se fait sur le drain du transistor $T_5$ commun. Il en est de même pour les portes $G_5$ et $G_6$. La sortie $\overline{Q}$ se fait sur le drain du transistor $T_5$ commun.

Pour obtenir un temps de transit $\tau_1 \geqslant (\tau_3 + \tau_4)$, alors que, au départ les portes du maître et de l'esclave sont identiques, on peut soit augmenter le temps de transit dans le maître, soit diminuer le temps de transit dans l'esclave. Mais on n'a pas intérêt à augmenter le temps de transit dans le maître, car alors on diminue la fréquence maximale à laquelle il est possible de faire fonctionner le circuit. Dans ces conditions, il faut diminuer le temps de transit dans l'esclave.

Une première solution consiste à grossir les transistors $T_1$ et $T_2$ des portes NON-OU de l'esclave, ce qui a l'inconvénient d'augmenter leur consommation. Mais on peut se permettre d'augmenter légèrement la consommation de l'esclave du fait que les portes du maître, de sortance 1, sont au contraire de faibles dimensions et dissipent extrêmement peu.

Une autre solution consiste à décaler le niveau du seuil des portes du maître. On obtient ainsi le ralentissement souhaité et on s'affranchit complètement des problèmes d'oscillation.

La solution qui présente finalement les meilleurs résultats consiste à jouer à la fois sur les dimensions des transistors et sur la polarisation des étages translateurs.

Dans une réalisation selon ce mode préférentiel, en appelant W la largeur unitaire de transistor, on a choisit pour dimensions de transistors celles qui sont représentées sur le tableau 4.

Dans le cas où $W = 20\,\mu m$, $V_{DD} = 4V$, $V_{SS} = -3V$ avec une tension de pincement $V_T = -2V$ et où la longueur de grille d'un transistor est $L = 0,6\,\mu m$. On arrive à une fréquence maximale $f_{max} = 5\,GHz$ et une puissance dissipée P: 280 mW.

Ce qui représente un progrès assez considérable, quand on sait que la valeur 4 GHz pour la fréquence, est très difficile à dépasser avec les circuits réalisés selon les schémas connus.

Le circuit selon la présente invention permet donc bien de réaliser un diviseur de fréquence par 2, dans le domaine des hyperfréquences, ce circuit étant intégré donc présentant une consommation faible et un prix de revient réduit.

## Revendications

1. Circuit intégré diviseur de fréquence par deux, du type bascule maître-esclave à deux sorties complémentaires Q et $\overline{Q}$ intégré à l'aide de transistors à effet de champ sur un substrat en arséniure de gallium, ne comportant qu'une entrée pour un signal de commande H du domaine des hyperfréquences, caractérisé en ce que d'abord le «maître» est constitué de deux portes NON-OU ($G_1$ et $G_2$), dont la première porte NON-OU ($G_1$) admet pour entrées le signal de commande H et le premier signal de sortie rebouclé $\overline{Q}$ et dont la deuxième porte NON-OU ($G_2$) admet pour entrées, le signal de commande H et le deuxième signal de sortie Q rebouclé, en ce que, ensuite, «l'esclave» est constitué de quatre portes NON-OU ($G_3$, $G_4$, $G_5$ et $G_6$) dont la première porte NON-OU ($G_3$) admet pour entrées le signal de sortie $E_1$ de la première porte NON-OU ($G_1$) du «maître» et le premier signal de sortie $\overline{Q}$ rebouclé, dont la seconde porte NON-OU ($G_4$) admet pour entrées le premier signal de sortie $\overline{Q}$ et le signal de commande H, dont la troisième porte NON-OU ($G_5$) admet pour entrées le signal de commande H et le deuxième signal de sortie Q rebouclé et dont la quatrième porte NON-OU ($G_6$) admet pour entrées le deuxième signal de sortie Q et le signal de sortie $E_2$ de la seconde porte NON-OU ($G_2$) du maître, les sorties des deux premières portes NON-OU ($G_3$ et $G_4$) de l'esclave étant reliées entre elles sous la forme d'un OU-CABLE ($G_7$) pour donner le deuxième signal de sortie Q et les sorties des deux dernières portes ($G_5$ et $G_6$) de l'esclave étant reliées entre elles sous forme d'un OU-CABLE ($G_8$) pour donner le premier signal de sortie $\overline{Q}$, et en ce que les différents transistors sont de dimensions telles que le temps de transit $\tau_1$ dans le maître ($G_1$, $G_2$), le temps de transit $\tau_3$ dans la première et la deuxième porte NON-OU ($G_3$, $G_4$) de l'esclave et le temps de transit $\tau_4$ dans la troisième et la quatrième porte NON-OU ($G_5$, $G_6$) dans l'esclave donnent l'inégalité suivante: $\tau_1 \geqslant (\tau_3 + \tau_4)$.

2. Circuit selon la revendication 1, caractérisé en ce qu'il est intégré à l'aide de transistors à effet de champ à désertion de charges sur un substrat en arséniure de gallium, dans une technologie incluant des portes du type inverseur suivi d'un étage translateur de niveau.

3. Circuit selon l'une des revendications 1 ou 2, caractérisé en ce que la fréquence du signal de commande utilisé est de l'ordre de 5 GHz et que la fréquence maximale de fonctionnement est définie par la relation $f_{max} = 1 / (\tau_1 + \tau_3 + \tau_4)$.

## Claims

1. An integrated divide-by-two frequence divider circuit of the master-slave flip-flop type which comprises two complementary outputs $Q$ and $\overline{Q}$, integrated on a gallium arsenide substrate by means of field effect transistors, and only one input for a control signal H in the microwave frequency range, characterized in that the «master» is formed by two NOR-gates ($G_1$ and $G_2$), the first of which ($G_1$) admits to the inputs the control signal H and the first fed back output signal $\overline{Q}$, the second NOR-gate ($G_2$) admitting to the inputs the control signal H and the second fed back output signal $Q$, the «slave» being formed by four NOR-gates ($G_3$, $G_4$, $G_5$ and $G_6$), the first of which ($G_3$) admits to the inputs the output signal $E_1$ of the first NOR-gate ($G_1$) of the «master» and the first fed back output signal $\overline{Q}$, the second NOR-gate ($G_4$) admitting to the inputs the first output signal $\overline{Q}$ and the control signal H, the third NOR-gate ($G_5$) admitting to the inputs the control signal H and the fed back second output signal $Q$, the fourth NOR-gate ($G_6$) admitting to the inputs the second fed back output signal $Q$ and the output signal $E_2$ of the second NOR-gate ($G_2$) of the master, the outputs of the first two NOR-gates ($G_3$ and $G_4$) of the slave being interconnected in the form of a wired-OR gate ($G_7$) in order to produce the second output signal $Q$, the outputs of the last two gates ($G_5$ and $G_6$) of the slave being interconnected in the form of a wired-OR gate ($G_8$) in order to produce the first output signal $\overline{Q}$, the various transistors being proportioned so that the transit time $\tau_1$ in the master ($G_1$, $G_2$), the transit time $\tau_3$ in the first and the second NOR-gate ($G_3$, $G_4$) of the slave, and the transit time $\tau_4$ in the third and the fourth NOR-gate ($G_5$, $G_6$) of the slave produced the following inequality: $\tau_1 \geqslant (\tau_3 + \tau_4)$.

2. A circuit as claimed in Claim 1, characterized in that it is integrated by means of depletion-type field effect transistors on a gallium arsenide substrate in a technology including inverter-type gates which are followed by a level translator stage.

3. A circuit as claimed in Claim 1 or 2, characterized in that the frequency of the control signal used is in the order of magnitude of 5 GHz, the maximum operating frequency being defined by the relation $f_{max} = 1 / (\tau_1 + \tau_3 + \tau_4)$.

## Patentansprüche

1. Frequenz-Zweiteiler-Integrationsschaltung vom Meister-Sklave-Flipfloptyp mit zwei komplementären Ausgängen $Q$ und $\overline{Q}$, die mit Hilfe von Feldeffekttransistoren auf einem Galliumarsenidsubstrat integriert sind, und mit nur einem Eingang für ein Befehlssignal H aus dem Gigahertzbereich, dadurch gekennzeichnet, dass zunächst der Meister aus zwei NICHT-ODER-Gattern ($G_1$ und $G_2$) besteht, von denen das erste NICHT-ODER-Gatter ($G_1$) das Steuersignal H und das erste zurückgekoppelte Ausgangssignal $\overline{Q}$ als Eingangssignale empfängt, und von denen das zweite NICHT-ODER-Gatter ($G_2$) das Steuersignal H und das zweite zurückgekoppelte Ausgangssignal $Q$ als Eingangssignale empfängt, dass weiter der Sklave aus vier NICHT-ODER-Gattern ($G_3$, $G_4$, $G_5$ und $G_6$) besteht, von denen das erste NICHT-ODER-Gatter ($G_3$) das Ausgangssignal ($G_1$) des ersten NICHT-ODER-Gatters ($G_1$) des Meisters und das erste zurückgekoppelte Ausgangssignal $\overline{Q}$ als Eingangssignale empfängt, von denen das zweite NICHT-ODER-Gatter ($G_4$) das erste Ausgangssignal $\overline{Q}$ und das Steuersignal H als Eingangssignale empfängt, von denen das dritte NICHT-ODER-Gatter ($G_5$) das Steuersignal H und das zweite zurückgekoppelte Ausgangssignal $Q$ als Eingangssignale empfängt, und von denen das vierte NICHT-ODER-Gatter ($G_6$) das zweite Ausgangssignal $Q$ und das Ausgangssignal $E_2$ des zweiten NICHT-ODER-Gatters ($G_2$) des Meisters als Eingangssignale empfängt, wobei die Ausgänge der zwei ersten NICHT-ODER-Gatter ($G_3$ und $G_4$) des Sklaven miteinander in Form eines verdrahteten ODER-Gatters ($G_7$) zum Liefern des zweiten Ausgangssignals $Q$ und die Ausgänge der zwei letzten Gatter ($G_5$ und $G_6$) des Sklaven miteinander in Form eines verdrahteten ODER-Gatters ($G_8$) zum Liefern des ersten Ausgangssignals $\overline{Q}$ verbunden sind, und dass die verschiedenen Transistoren derart bemessen sind, dass die Laufzeit $\tau_3$ im ersten und im zweiten NICHT-ODER-Gatter ($G_3$, $G_4$) des Sklaven und die Laufzeit $\tau_4$ im dritten und im vierten NICHT-ODER-Gatter ($G_5$, $G_6$) des Sklaven folgende Ungleichheit ergeben: $\tau_1 \geqslant (\tau_3 + \tau_4)$.

2. Schaltung nach Anspruch 1, dadurch gekennzeichnet, dass sie mit Hilfe von Verarmungs-Feldeffekttransistoren auf einem Galliumarsenidsubstrat integriert ist, wobei eine Technologie benutzt wird, bei der invertierende Gatter gefolgt von einer Pegelübersetzerstufe verwendet werden.

3. Schaltung nach einem der Ansprüche 1 oder 2, dadurch gekennzeichnet, dass die Frequenz des benutzten Steuersignals eine Grössenordnung von 5 GHz besitzt und dass die Höchstbetriebfrequenz durch die Beziehung $f_{max} = 1 / (\tau_1 + \tau_3 + \tau_4)$ bestimmt wird.

FIG.1

$S = \overline{I_1 + I_2}$

FIG.2a

FIG.2b

0130645

FIG.3

11

| | $G_1$ et $G_2$ | $G_3$ et $G_6$ | $G_4$ et $G_5$ |
|---|---|---|---|
| $T_1$ et $T_2$ | 0,8 W | 1,25 W | 2,5 W |
| $T_3$ | 0,6 W | W | W |
| $T_4$ | W | 2,5 W | 2,5 W |
| $T_5$ | | 4,25 W | |
| $D_1$ et $D_2$ | 0,85 W | 4,25 W | |

FIG. 4